# EUROPÄISCHE PATENTSCHRIFT

(11) **EP 2 695 182 B1**
(45) Veröffentlichungstag und Bekanntmachung des Hinweises auf die Patenterteilung: **30.03.2016**
(21) Anmeldenummer: 11713274.6
(22) Anmeldetag: 08.04.2011
(51) Int. Cl.: H01L 21/20, H01L 21/762

(54) **VERFAHREN ZUM PERMANENTEN BONDEN VON WAFERN**
METHOD FOR PERMANENTLY BONDING WAFERS
PROCÉDÉ DE LIAISON PERMANENTE DE PLAQUETTES DE SEMI-CONDUCTEURS

(43) Veröffentlichungstag der Anmeldung: 12.02.2014
(73) Patentinhaber: Ev Group E. Thallner GmbH, 4782 St. Florian am Inn (AT)
(72) Erfinder: PLACH, Thomas, 4651 Stadl-Paura (AT); HINGERL, Kurt, 4493 Wolfern (AT); WIMPLINGER, Markus, 4910 Ried im Innkreis (AT); FLÖTGEN, Christoph, 4782 Pramerdorf (AT)
(74) Vertreter: Schweiger, Johannes
(86) Internationale Anmeldenummer: PCT/EP2011/055471
(87) Internationale Veröffentlichungsnummer: WO 2012/136268

(56) Entgegenhaltungen:
- US-A1- 2006 240 642
- US-A1- 2010 029 058
- SUNI T ET AL: "EFFECTS OF PLASMA ACTIVATION ON HYDROPHOLIC BONDING OF SI AND SIO2", JOURNAL OF THE ELECTROCHEMICAL SOCIETY, ELECTROCHEMICAL SOCIETY. MANCHESTER, NEW HAMPSHIRE, US, Bd. 149, Nr. 6, 1. Juni 2002 (2002-06-01), Seiten G348-G351, XP008046162, ISSN: 0013-4651, DOI: 10.1149/1.1477209
- WEINERT A ET AL: "Plasma assisted room temperature bonding for MST", SENSORS AND ACTUATORS A, ELSEVIER SEQUOIA S.A., LAUSANNE, CH, Bd. 92, Nr. 1-3, 1. August 2001 (2001-08-01), Seiten 214-222, XP004274049, ISSN: 0924-4247, DOI: 10.1016/S0924-4247(01)00579-9

## Beschreibung

Die vorliegende Erfindung betrifft ein Verfahren zum Bonden einer ersten Kontaktfläche eines ersten Substrats mit einer zweiten Kontaktfläche eines zweiten Substrats gemäß Patentanspruch 1.

Ziel beim permanenten oder irreversiblen Bonden von Substraten ist es, zwischen den beiden Kontaktflächen der Substrate eine möglichst starke und insbesondere unwiderrufliche Verbindung, also eine hohe Bondkraft, zu erzeugen. Hierfür existieren im Stand der Technik verschiedene Ansätze und Herstellungsverfahren.

Die bekannten Herstellungsverfahren und bisher verfolgten Ansätze führen häufig zu nicht oder schlecht reproduzierbaren und insbesondere kaum auf veränderte Bedingungen übertragbaren Ergebnissen. Insbesondere benutzen derzeit eingesetzte Herstellungsverfahren häufig hohe Temperaturen, insbesondere >400°C, um wiederholbare Ergebnisse zu gewährleisten.

Technische Probleme wie hoher Energieverbrauch und eine mögliche Zerstörung von auf den Substraten vorhandenen Strukturen resultieren aus den bisher für eine hohe Bondkraft erforderlichen hohen Temperaturen von teilweise weit über 300°C.

Weitere Anforderungen bestehen in:
- der Front-end-of-line-Kompatibilität.
   Darunter versteht man die Kompatibilität des Prozesses während der Herstellung der elektrisch aktiven Bauteile. Der Bondingprozess muss also so ausgelegt werden, dass aktive Bauelemente wie Transistoren, die bereits auf den Strukturwafern vorhanden sind, während der Prozessierung weder beeinträchtigt noch geschädigt werden. Zu den Kompatibilitätskriterien zählen vor allem die Reinheit an gewissen chemischen Elementen (vor allem bei CMOS Strukturen), mechanische Belastbarkeit, vor allem durch Thermospannungen.
- niedrige Kontamination.
- keine Krafteinbringung.
- möglichst niedrige Temperatur, insbesondere bei Materialien mit unterschiedlichem Wärmeausdehnungskoeffizienten.

Die Reduktion der Bondkraft führt zu einer schonenderen Behandlung der Strukturwafer, und damit zu einer Reduktion der Ausfallswahrscheinlichkeit durch direkte mechanische Belastung.

US2009/0098709 offenbart ein Verfahren zum bonden von Wafern mit einer TEOS Schicht auf einem der Substrate, wobei die Temperatur zum Ausbilden eines permanenten Bonds zwischen 200°C und 450°C liegt. US2007/0020947 offenbart ein weiteres Verfahren zum bonden von Wafern mit einer TEOS Schicht auf einem der Substrate.

Aufgabe der vorliegenden Erfindung ist es daher, ein Verfahren zur schonenden Herstellung eines permanenten Bonds mit einer möglichst hohen Bondkraft bei gleichzeitig möglichst niedriger Temperatur anzugeben.

Diese Aufgabe wird mit den Merkmalen des Patentanspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, zumindest an einem der Substrate ein Reservoir zur Aufnahme eines ersten Edukts zu schaffen, das nach der Kontaktierung beziehungsweise Herstellung eines vorläufigen Bonds zwischen den Substraten mit einem zweiten Edukt, das in einem der beiden Substrate, insbesondere in einer Reaktionsschicht, vorliegt, zu reagieren und dadurch einen irreversiblen beziehungsweise permanenten Bond zwischen den Substraten auszubilden. Vor oder nach der Ausbildung des Reservoirs in einer Reservoirbildungsschicht in dem ersten und/oder zweiten Substrat findet meist eine Reinigung des oder der Substrate, insbesondere durch einen Spülschritt, statt. Diese Reinigung soll zumeist sicherstellen, dass sich keine Partikel auf den Oberflächen befinden, die ungebondete Stellen zur Folge haben würden.

Nach Ausbildung des oder der Reservoirs wird erfindungsgemäß zur Verkürzung der Abstände zwischen den Edukten mindestens eine Reaktionsschicht auf mindestens eines der Reservoirs aufgebracht oder auf diesen ausgebildet. Die Reaktionsschicht besteht insbesondere aus dem zweiten Edukt, vorzugsweise einem oxidierbaren Material, noch bevorzugter aus Silizium.

Durch das Reservoir und das im Reservoir enthaltene Edukt wird eine technische Möglichkeit geschaffen, unmittelbar an den Kontaktflächen nach der Herstellung des vorläufigen beziehungsweise reversiblen Bonds gezielt eine den permanenten Bond verstärkende und die Bondgeschwindigkeit erhöhende Reaktion (erstes Edukt oder erste Gruppe mit dem zweiten Edukt oder der zweiten Gruppe) zu induzieren, insbesondere durch Verformung mindestens einer der Kontaktflächen durch die Reaktion, vorzugsweise der dem Reservoir gegenüberliegenden Kontaktfläche oder beider Kontaktflächen.

Für den Pre-Bonding-Schritt zur Erzeugung eines vorläufigen oder reversiblen Bonds zwischen den Substraten sind verschiedene Möglichkeiten vorgesehen mit dem Ziel, eine schwache Interaktion zwischen den Kontaktflächen der Substrate zu erzeugen. Die Prebondstärken liegen dabei unter den Permanentbondstärken, zumindest um den Faktor 2 bis 3, insbesondere um den Faktor 5, vorzugsweise um den Faktor 15, noch bevorzugter um den Faktor 25. Als Richtgrößen werden die Pre-Bondstärken von reinem, nicht aktiviertem, hydrophilisierten Silizium mit ca. 100mJ/m² und von reinem, plasmaaktivierten hydrophiliserten Silizium mit ca. 200-300mJ/m² erwähnt. Die Prebonds zwischen den mit Molekülen benetzten Substraten kommen hauptsächlich durch die van-der-Waals Wechselwirkungen zwischen den Molekülen der unterschiedlichen Waferseiten zustande. Dementsprechend sind vor allem Moleküle mit permanenten Dipolmomenten dafür geeignet, Prebonds zwischen Wafern zu ermöglichen. Als Verbindungsmittel werden folgende chemische Verbindungen beispielhaft, aber nicht einschränkend, genannt
- Wasser,
- Tiole,
- AP3000,
- Silane und/oder
- Silanole

Als erfindungsgemäße Substrate sind solche Substrate geeignet, deren Material in der Lage ist, als Edukt mit einem weiteren zugeführten Edukt zu einem Produkt mit einem höheren molaren Volumen zu reagieren, wodurch die Bildung einer Aufwuchsschicht auf dem Substrat bewirkt wird. Besonders vorteilhaft sind die nachfolgenden Kombinationen, wobei jeweils links vom Pfeil das Edukt und rechts vom Pfeil das Produkt / die Produkte genannt ist, ohne das mit dem Edukt reagierende zugeführte Edukt oder Nebenprodukte im Einzelnen zu benennen:
- Si→SiO₂, Si₃N₄, SiNₓO_{y}
- Ge→ GeO₂, Ge₃N₄
- α-Sn→ SnO₂
- B→ B₂O₃, BN
- Se→ SeO₂
- Te→ TeO₂, TeO₃
- Mg→ MgO, Mg₃N₂
- Al→ Al₂O₃, AlN
- Ti→ TiO₂, TiN
- V→ V₂O₅
- Mn→ MnO, MnO₂, Mn₂O₃, Mn₂O₇, Mn₃O₄
- Fe → FeO, Fe₂O₃, Fe₃O₄
- Co→ CoO, Co₃O₄,
- Ni→ NiO, Ni₂O₃
- Cu→ CuO Cu₂O, Cu₃N
- Zn→ ZnO
- Cr→ CrN, Cr₂₃C₆, Cr₃C, Cr₇C₃, Cr₃C₂
- Mo→ MO₃C₂
- Ti→ TiC
- Nb→ Nb₄C₃
- Ta→ Ta₄C₃
- Zr→ ZrC
- Hf→ HfC
- V→ V₄C₃, VC
- W→ W₂C, WC
- Fe→ Fe₃C, Fe₇C₃, Fe₂C.

Als Substrate sind außerdem folgende Mischformen von Halbleitern denkbar:
- III-V: GaP, GaAs, InP, InSb, InAs, GaSb, GaN, AlN, InN, AlₓGa₁₋ₓAs, InₓGa₁₋ₓN
- IV-IV: SiC, SiGe,
- III-VI: InAlP.
- nichtlineare Optik: LiNbO₃, LiTaO₃, KDP (KH₂PO₄)
- Solarzellen: CdS, CdSe, CdTe, CuInSe₂, CuInGaSe₂, CuInS₂, CuInGaS₂
- Leitende Oxide: In₂₋ₓSnxO_{3-y}

Erfindungsgemäß wird das Reservoir (oder die Reservoirs) an mindestens einem der Wafer vorgesehen, in welchem eine gewisse Menge mindestens eines der zugeführten Edukte für die Volumenexpansionsreaktion speicherbar ist. Edukte können also beispielsweise O₂, O₃, H₂O, N₂, NH₃, H₂O₂ etc. sein. Durch die Expansion, insbesondere bedingt durch Oxidwachstum, werden auf Grund der Bestrebung der Reaktionspartner, die Systemenergie abzusenken, etwaige Lücken, Poren, Hohlräume zwischen den Kontaktflächen minimiert und die Bondkraft entsprechend durch Annäherung der Abstände zwischen den Substraten in diesen Bereichen erhöht. Im bestmöglichen Fall werden die vorhandenen Lücken, Poren und Hohlräume komplett geschlossen, sodass die gesamte Bondingfläche zunimmt und damit die Bondkraft erfindungsgemäß entsprechend steigt. Indem auf dem Reservoir eine, insbesondere dünner als das Reservoir, vorzugsweise mindestens halb so dünn, ausgebildete Reaktionsschicht, inbesondere zumindest überwiegend aus dem zweiten Edukt bestehend, aufgebracht beziehungsweise ausgebildet wird, wird die Reaktion zwischen dem ersten und dem zweiten Edukt zum Anwachsen der Aufwuchsschicht beschleunigt. Erfindungsgemäß erfolgt die Auswahl der Dicke der aufgebrachten Reaktionsschicht so, dass im Wesentlichen die gesamte Reaktionsschicht während der Reaktion des ersten mit dem zweiten Edukt konsumiert wird. Entsprechend der Größe der Reaktionsschicht wird auch die Ausbildung des Reservoirs und Auffüllung des Reservoirs gesteuert. Die Dicke der zusätzlich aufgebrachten Reaktionsschicht liegt insbesondere zwischen 1 und 15nm, vorzugsweise zwischen 2 und 10nm, noch bevorzugter zwischen 3 und 5 nm.

Besonders vorteilhaft ist es erfindungsgemäß, wenn nach der Aufbringung der zusätzlichen Reaktionsschicht möglichst zeitnah, insbesondere innerhalb von 2 Stunden, vorzugsweise innerhalb von 30 Minuten, noch bevorzugter innerhalb von 10 Minuten, idealerweise innerhalb von 5 Minuten die Kontaktierung erfolgt. Durch diese Maßnahme werden etwaige unerwünschte Reaktionen wie Oxidierung der Reaktionsschicht minimiert.

Erfindungsgemäß können Mittel zur Hemmung solcher Reaktionen der Reaktionsschicht vor dem Kontaktieren der Kontaktflächen vorgesehen sein, insbesondere durch Passivierung der Reaktionsschicht des zweiten Substrats, vorzugsweise durch Beaufschlagung mit N₂, Formiergas oder einer inerten Atmosphäre oder unter Vakuum oder durch Amorphisieren. Als besonders geeignet hat sich in diesem Zusammenhang eine Behandlung mit Plasma, welches Formiergas enthält, insbesondere überwiegend aus Formiergas besteht, erwiesen. Als Formiergas sind hier Gase zu verstehen, die mindestens 2%, besser 4%, idealerweise 10% oder 15% Wasserstoff enthalten. Der restliche Anteil der Mischung besteht aus einem inerten Gas wie beispielsweise Stickstoff oder Argon. Systeme mit inerter Atmosphäre oder Vakuum Atmosphäre lassen sich mit Vorzug als Systeme realisieren, bei denen der Transfer der Substrate von einer Prozesskammer zur nächsten Prozesskammer mittels eines Substrat Handhabungssystems geschieht, welches den Transfer der Substrate vollständig in einer kontrollierten, einstellbaren Atmosphäre, insbesondere einer Vakuum Atmosphäre durchführen kann. Derartige Systeme sind in der Industrie üblich und dem Fachmann bekannt.

Die Kontaktflächen zeigen üblicherweise eine Rauhigkeit mit einer quadratischen Rauheit (Rq) von 0,2 nm auf. Dies entspricht Scheitel-ScheitelWerten der Oberflächen im Bereich von 1 nm. Diese empirischen Werte wurden mit der Atomic Force Microscopy (AFM) ermittelt.

Die erfindungsgemäße Reaktion ist geeignet, bei einer üblichen Waferfläche eines kreisförmigen Wafers mit einem Durchmesser von 200 bis 300 mm mit 1 Monolage (ML) Wasser die Aufwuchsschicht um 0,1 bis 0,3 nm wachsen zu lassen.

Erfindungsgemäß ist daher insbesondere vorgesehen, mindestens 2 ML, vorzugsweise mindestens 5 ML, noch bevorzugter mindestens 10 ML Fluid, insbesondere Wasser, im Reservoir zu speichern.

Besonders bevorzugt ist die Ausbildung des Reservoirs durch Plasmabeaufschlagung, da durch die Plasmabeaufschlagung außerdem eine Glättung der Kontaktfläche sowie eine Hydrophilisierung als Synergieeffekte bewirkt werden. Die Glättung der Oberfläche durch Plasmaaktivierung erfolgt vorwiegend durch einen viskosen Fluss des Materials der Reservoirbildungsschicht. Die Erhöhung der Hydrophilizität erfolgt insbesondere durch die Vermehrung der Siliziumhydroxyl Verbindungen, vorzugsweise durch Cracken von an der Oberfläche vorhandenen Si-O Verbindungen wie Si-O-Si, insbesondere gemäß nachfolgender Reaktion:

Si-O-Si + H₂O ←→ 2SiOH

Ein weiterer Nebeneffekt, insbesondere als Folge der vorgenannten Effekte, besteht darin, dass die Pre-Bond-Stärke, insbesondere um einen Faktor 2 bis 3, verbessert wird.

Die Ausbildung des Reservoirs in der Reservoirbildungsschicht an der ersten Kontaktfläche des ersten Substrats (und gegebenenfalls einer Reservoirbildungsschicht an der zweiten Kontaktfläche des zweiten Substrats) erfolgt beispielsweise durch Plasmaaktivierung des mit einem thermischen Oxid beschichteten ersten Substrats. Die Plasmaaktivierung wird in einer Vakuumkammer durchgeführt, um die für das Plasma erforderlichen Bedingungen einstellen zu können. Erfindungsgemäß wird für die Plasmaentladung N₂-Gas, O₂-Gas oder Argongas mit Ionenenergien im Bereich von 0 bis 2000 eV verwendet, wodurch ein Reservoir mit einer Tiefe von bis zu 20 nm, vorzugsweise bis zu 15 nm, mit größerem Vorzug bis zu 10 nm, mit größtem Vorzug bis zu 5 nm, der behandelten Oberfläche, in diesem Fall der ersten Kontaktfläche, hergestellt wird. Erfindungsgemäß können jede Partikelart, Atome und/oder Moleküle, verwendet werden, die geeignet sind, das Reservoir zu erzeugen. Mit Vorzug werden jene Atome und/oder Moleküle verwendet, welche das Reservoir mit den benötigten Eigenschaften erzeugt. Die relevanten Eigenschaften sind vor allem die Porengröße, Porenverteilung und Porendichte. Alternativ können erfindungsgemäß Gasmischungen, wie beispielsweise Luft oder Formiergas bestehend aus 95% Ar und 5% H₂ verwendet werden. Abhängig von dem verwendeten Gas sind in dem Reservoir während der Plasmabehandlung unter anderem folgende Ionen anwesend: N+, N₂+, O+, O₂+, Ar+. Im nicht belegten Freiraum des/der Reservoirs ist das erste Edukt aufnehmbar. Die Reservoirbildungsschicht und entsprechend das Reservoir kann sich bis in die Reaktionsschicht hinein erstrecken.

Mit Vorteil handelt es sich dabei um unterschiedliche Arten von Plasmaspezies, die mit der Reaktionsschicht reagieren können und zumindest teilweise, vorzugsweise überwiegend aus dem ersten Edukt bestehen. Soweit das zweite Edukt Si/Si ist, wäre eine Oₓ-Plasmaspezies vorteilhaft.

Die Ausbildung des/der Reservoirs erfolgt auf Grund folgender Überlegungen:
Die Porengröße ist kleiner als 10 nm, mit Vorzug kleiner als 5 nm, mit größerem Vorzug kleiner als 1 nm, mit noch größerem Vorzug kleiner als 0.5 nm, mit größtem Vorzug kleiner als 0.2 nm.

Die Porendichte ist mit Vorzug direkt proportional zur Dichte der Partikel, welche die Poren durch Einschlagwirkung erzeugen, mit größtem Vorzug sogar durch den Partialdruck der Einschlagspezies variierbar, sowie abhängig von der Behandlungszeit und den Parametern, insbesondere des verwendeten Plasmasystems.

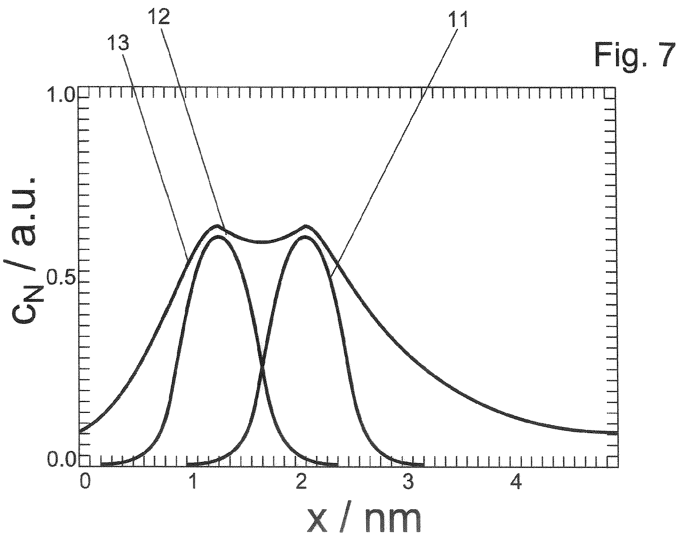

Die Porenverteilung besitzt mit Vorzug mindestens einen Bereich größter Porenkonzentration unter der Oberfläche, durch Variation der Parameter mehrerer solcher Bereiche, welche sich zu einem, vorzugsweise plateauförmigen Bereich, überlagern (siehe Fig. 7). Die Porendichte konvergiert mit zunehmender Tiefe gegen null. Der oberflächennahe Bereich besitzt während des Beschusses eine Porendichte, welche mit der Porendichte nahe der Oberfläche beinahe ident ist. Nach dem Ende der Plasmabehandlung kann die Porendichte an der Oberfläche auf Grund von Spannungsrelaxationsmechanismen verringert werden. Die Porenverteilung in Dickenrichtung besitzt bezüglich der Oberfläche eine steile Flanke und bezüglich des Bulks eine eher flachere, aber stetig abnehmende Flanke (siehe Fig. 7).

Für die Porengröße, die Porenverteilung und Porendichte gelten für alle nicht mit Plasma hergestellten Verfahren ähnliche Überlegungen.

Das Reservoir kann durch gezielte Verwendung und Kombination von Prozessparametern designed werden. Fig. 7 zeigt eine Darstellung der Konzentration eingeschossener Stickstoffatome durch Plasma als Funktion der Eindringtiefe in eine Siliziumoxidschicht. Durch Variation der physikalischen Parameter konnten zwei Profile erzeugt werden. Das erste Profil 11 wurde durch stärker beschleunigte Atome tiefer im Siliziumoxid erzeugt, wohingegen das Profil 12, nach Abänderung der Prozessparameter in einer geringeren Dichte erzeugt wurde. Die Überlagerung beider Profile ergibt eine Summenkurve 13, welche charakteristisch für das Reservoir steht. Der Zusammenhang zwischen der Konzentration der eingeschossenen Atom und/oder Molekülspezies ist evident. Höhere Konzentrationen bezeichnen Gebiete mit höherer Defektstruktur, also mehr Raum um das anschließende Edukt aufzunehmen. Eine kontinuierliche, insbesondere gezielt gesteuerte kontinuierliche Änderung der Prozessparameter während der Plasmaaktivierung ermöglicht es, ein Reservoir mit einer möglichst gleichmäßigen Verteilung der eingebrachten Ionen über die Tiefe zu erreichen.

Als Reservoir ist alternativ zu einem durch Plasma erzeugten Reservoir die Verwendung einer TEOS (Tetraethylorthosilikat)-Oxidschicht auf mindestens einem der Substrate, zumindest dem ersten Substrat, denkbar. Dieses Oxid ist im allgemeinen weniger dicht als thermisches Oxid, weshalb erfindungsgemäß eine Verdichtung vorteilhaft ist. Die Verdichtung erfolgt durch Wärmebehandlung mit dem Ziel einer Einstellung einer definierten Porosität des Reservoirs.

Besonders vorteilhaft kann gemäß einer Ausführungsform der Erfindung die Auffüllung des Reservoirs gleichzeitig mit der Ausbildung des Reservoirs erfolgen, indem das Reservoir als Beschichtung auf dem ersten Substrat aufgebracht wird, wobei die Beschichtung das erste Edukt bereits umfasst.

Das Reservoir ist als poröse Schicht mit einer Porosität im Nanometerbereich oder als Kanäle aufweisende Schicht mit einer Kanaldicke kleiner 10 nm, mit größerem Vorzug kleiner als 5 nm, mit noch größerem Vorzug kleiner als 2 nm, mit größtem Vorzug kleiner als 1 nm, mit allergrößtem Vorzug kleiner als 0.5 nm denkbar.

Für den Schritt des Auffüllens des Reservoirs mit dem ersten Edukt oder einer ersten Gruppe von Edukten sind erfindungsgemäß folgende Ausführungsformen, auch in Kombination, denkbar:
- Aussetzen des Reservoirs gegenüber der Umgebungsatmosphäre,
- Spülung mit, insbesondere deionisiertem, Wasser,
- Spülen mit einem das Edukt enthaltenden oder aus diesem bestehenden Fluid, insbesondere H₂O, H₂O₂, NH₄OH
- Aussetzen des Reservoirs gegenüber einer beliebigen Gasatmosphäre, insbesondere atomares Gas, molekulares Gas, Gasmischungen,
- Aussetzen des Reservoirs gegenüber einer Wasserdampf oder Wasserstoffperoxiddampf enthaltenden Atmosphäre und
- Ablagerung eines bereits mit dem Edukt befüllten Reservoirs als Reservoirbildungsschicht auf dem ersten Substrat.

Als Edukte kommen die folgenden Verbindungen in Frage: O_{X}⁺, O₂, O₃, N₂, NH₃, H₂O, H₂O₂ und/oder NH₄OH.

Die Verwendung des oben angeführten Wasserstoffperoxiddampfes wird neben der Verwendung von Wasser als bevorzugte Variante angesehen. Wasserstoffperoxid hat des Weiteren den Vorteil, ein größeres Sauerstoff zu Wasserstoffverhältnis zu besitzen. Des Weiteren dissoziiert Wasserstoffperoxid über bestimmten Temperaturen und/oder der Verwendung von Hochfrequenzfeldern im MHz Bereich zu Wasserstoff und Sauerstoff.

Vor allem bei Verwendung von Materialien mit unterschiedlichen thermischen Ausdehnungskoeffizienten ist die Anwendung von Verfahren zur Dissoziierung der vorgenannten Spezies vorteilhaft, die keine nennenswerte oder allenfalls eine lokale/spezifische Temperaturerhöhung bewirken. Insbesondere ist eine Mikrowellenbestrahlung vorgesehen, welche die Dissoziierung zumindest begünstigt, vorzugsweise bewirkt.

Die (zusätzlich aufgebrachte) Reaktionsschicht wird durch eines oder mehrere der nachfolgend genannten Verfahren aufgebracht:
- PECVD,
- LPCVD,
- Aufdampfen und
- Epitaxie.
- MOCVD

Gemäß einer vorteilhaften Ausführungsform der Erfindung ist vorgesehen, dass die Ausbildung der Aufwuchsschicht und Verstärkung des irreversiblen Bonds durch Diffusion des ersten Edukts in die Reaktionsschicht erfolgt.

Gemäß einer weiteren, vorteilhaften Ausführungsform der Erfindung ist vorgesehen, dass die Ausbildung des irreversiblen Bonds bei einer Temperatur von typischerweise weniger als 300 °C, mit Vorteil von weniger als 200 °C, mit größerem Vorzug weniger als 150 °C, mit noch größerem Vorzug weniger als 100 °C, mit größtem Vorzug bei Raumtemperatur insbesondere während maximal 12 Tage, bevorzugter maximal 1 Tag, noch bevorzugter maximal 1 Stunde, am bevorzugtesten maximal 15 Minuten, erfolgt. Eine weitere, vorteilhafte Wärmebehandlungsmethode ist die dielektrische Erwärmung durch Mikrowellen.

Dabei ist es besonders vorteilhaft, wenn der irreversible Bond eine Bondstärke von größer 1,5 J/m², insbesondere größer 2 J/m², vorzugsweise größer 2,5 J/m² aufweist.

Die Bondstärke kann in besonders vorteilhafter Weise dadurch erhöht werden, dass bei der Reaktion erfindungsgemäß ein Produkt mit einem größeren molaren Volumen als das molare Volumen des zweiten Edukts in der Reaktionsschicht gebildet wird. Hierdurch wird ein Anwachsen am zweiten Substrat bewirkt, wodurch Lücken zwischen den Kontaktflächen durch die erfindungsgemäße chemische Reaktion geschlossen werden können. Als Folge hieraus wird der Abstand zwischen den Kontaktflächen, also der mittlere Abstand, reduziert und Toträume minimiert.

Soweit die Ausbildung des Reservoirs durch Plasmaaktivierung, insbesondere mit einer Aktivierungsfrequenz zwischen 10 und 600 kHz und/oder einer Leistungsdichte zwischen 0,075 und 0,2 Watt/cm² und/oder unter Druckbeaufschlagung mit einem Druck zwischen 0,1 und 0,6 mbar, erfolgt, werden zusätzliche Effekte wie die Glättung der Kontaktfläche als auch eine deutlich erhöhte Hydrophilität der Kontaktfläche bewirkt.

Alternativ dazu kann die Ausbildung des Reservoirs erfindungsgemäß durch Verwendung einer, insbesondere kontrolliert auf eine bestimmte Porosität verdichteten, Tetraethoxysilan-Oxidschicht als Reservoirbildungsschicht erfolgen.

Gemäß einer weiteren vorteilhaften Ausführungsform der Erfindung ist vorgesehen, dass die Reservoirbildungsschicht überwiegend, insbesondere im wesentlichen vollständig, aus einem, insbesondere amorphen, insbesondere einem durch thermische Oxidation erzeugten Siliziumdioxid, und die Reaktionsschicht aus einem oxidierbaren Material, insbesondere überwiegend, vorzugsweise im Wesentlichen vollständig, aus Si, Ge, InP, GaP oder GaN (oder einem anderen, oben alternativ erwähnten Material), bestehen. Durch Oxidation wird eine besonders stabile und die vorhandenen Lücken besonders effektiv schließende Reaktion ermöglicht.

Zusätzlich zu der nach Ausbildung des/der Reservoirs aufgebrachten Reaktionsschicht kann unter jedem Reservoir erfindunggemäß eine weitere Reaktionsschicht vorgesehen sein, insbesondere jeweils überwiegend bestehend aus dem zweiten Edukt oder der zweiten Gruppe. Mit anderen Worten ist erfindungsgemäß vorgesehen, dass das erste Substrat (1) eine Reaktionsschicht und/oder das zweite Substrat eine Reaktionsschicht, zumindest überwiegend bestehend aus dem zweiten Edukt oder der zweiten Gruppe, benachbart zu den Reservoirbildungsschichten aufweisen

Dabei ist es erfindungsgemäß besonders vorteilhaft, wenn die Reservoirbildungsschicht und/oder die Reaktionsschicht als Aufwuchsschicht wirken. Die Aufwuchsschicht unterliegt einem durch die erfindungsgemäße Reaktion bewirkten Wachstum. Das Wachstum erfolgt ausgehend vom Übergang Si-SiO₂ durch Neubildung von amorphem SiO₂ und dadurch hervorgerufener Verformung, insbesondere Ausbeulung, der Aufwuchsschicht, insbesondere an der Grenzfläche zur Reaktionsschicht, und zwar insbesondere in Bereichen von Lücken zwischen der ersten und der zweiten Kontaktfläche. Hierdurch wird eine Reduzierung des Abstands beziehungsweise Verringerung des Totraums zwischen den beiden Kontaktflächen bewirkt, wodurch die Bondstärke zwischen den beiden Substraten erhöht wird. Besonders vorteilhaft ist dabei eine Temperatur zwischen 200 und 400 °C, bevorzugt in etwa 200 °C und 150 °C, bevorzugterweise eine Temperatur zwischen 150 °C und 100 °C, am bevorzugtesten eine Temperatur zwischen 100°C und Raumtemperatur. Die Aufwuchsschicht kann dabei in mehrere Aufwuchsbereiche unterteilt sein. Die Aufwuchsschicht kann gleichzeitig eine Reservoirbildungsschicht des zweiten Substrats sein, in der ein weiteres, die Reaktion beschleunigendes Reservoir ausgebildet wird.

Hierbei ist es besonders vorteilhaft, wenn die Aufwuchsschicht vor der Ausbildung des irreversiblen Bonds eine mittlere Dicke A zwischen 0,1 nm und 5 nm aufweist. Je dünner die Aufwuchsschicht, desto schneller und einfacher erfolgt die Reaktion zwischen dem ersten und dem zweiten Edukt durch die Aufwuchsschicht hindurch, insbesondere durch Diffusion des ersten Edukts durch die Aufwuchsschicht hindurch zur Reaktionsschicht. Durch die, insbesondere gedünnte und dadurch zumindest beim Beginn der Ausbildung des permanenten Bonds beziehungsweise beim Beginn der Reaktion sehr dünne, Aufwuchsschicht wird die Diffusionsrate der Edukte durch die Aufwuchsschicht hindurch erhöht. Dies führt zu einer geringeren Transportzeit der Edukte bei gleicher Temperatur.

In vorteilhafter Weise ist gemäß einer Ausführungsform der Erfindung vorgesehen, dass die Ausbildung des Reservoirs im Vakuum durchgeführt wird. Somit können Verunreinigungen des Reservoirs mit nicht erwünschten Materialien oder Verbindungen vermieden werden.

In einer weiteren Ausführungsform der Erfindung ist mit Vorteil vorgesehen, dass das Auffüllen des Reservoirs durch einen oder mehrere der nachfolgend aufgeführten Schritte erfolgt:
- Aussetzen der ersten Kontaktfläche gegenüber der Atmosphäre, zur Auffüllung des Reservoirs mit Luftfeuchtigkeit und / oder in der Luft enthaltenem Sauerstoff.
- Beaufschlagung der ersten Kontaktfläche mit einem, insbesondere überwiegend, vorzugsweise nahezu vollständig, aus, insbesondere deionisiertem, H₂O und/oder H₂O₂ bestehenden, Fluid,
- Beaufschlagung der ersten Kontaktfläche mit N₂-Gas und/oder O₂-Gas und/oder Ar-Gas und/oder Formiergas, insbesondere bestehend aus 95% Ar und 5% H₂, insbesondere mit einer Ionenenergie im Bereich von 0 bis 2000 eV.
- Bedampfung zur Auffüllung des Reservoirs mit einem beliebigen bereits genannten Edukt.

Besonders effektiv für den Verfahrensablauf ist es, wenn das Reservoir mit Vorzug in einer Dicke R zwischen 0,1 nm und 25 nm, mit größerem Vorzug zwischen 0,1 nm und 15 nm, mit noch größerem Vorzug zwischen 0,1 nm und 10 nm, mit größtem Vorzug zwischen 0,1 nm und 5 nm ausgebildet wird. Weiterhin ist es gemäß einer Ausführungsform der Erfindung vorteilhaft, wenn der mittlere Abstand B zwischen dem Reservoir und der Reaktionsschicht des gegenüberliegenden Substrats unmittelbar vor der Ausbildung des irreversiblen Bonds zwischen 0,1 nm und 15 nm, insbesondere zwischen 0,5 nm und 5 nm, vorzugsweise zwischen 0,5 nm und 3 nm beträgt. Der Abstand B kann durch Dünnen beeinflusst werden.

Eine Vorrichtung zur Ausführung des Verfahrens ist erfindungsgemäß mit einer Kammer zur Ausbildung des Reservoirs und einer, insbesondere separat dazu vorgesehenen Kammer zur Füllung des Reservoirs und einer, insbesondere separat vorgesehenen Kammer zur Ausbildung des Pre-Bonds ausgebildet, die direkt über ein Vakuumsystem miteinander verbunden sind.

In einer weiteren Ausführungsform kann das Auffüllen des Reservoirs auch direkt über die Atmosphäre erfolgen, also entweder in einer Kammer, die zur Atmosphäre hin geöffnet werden kann oder einfach auf einem Aufbau, welcher keine Ummantelung besitzt aber den Wafer semi- und/oder vollautomatisch handhaben kann.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: einen ersten Schritt des erfindungsgemäßen Verfahrens unmittelbar nach der Kontaktierung des ersten Substrats mit dem zweiten Substrat,
- Figur 1b: einen alternativen ersten Schritt des erfindungsgemäßen Verfahrens unmittelbar nach der Kontaktierung des ersten Substrats mit dem zweiten Substrat,
- Figur 2a und 2b: weitere Schritte des erfindungsgemäßen Verfahrens zur Ausbildung einer höheren Bondstärke,
- Figur 3: einen sich an die Schritte gemäß Figur 1, Figur 2a und Figur 2b anschließender weiterer Schritt des erfindungsgemäßen Verfahrens mit in Kontakt stehenden Kontaktflächen der Substrate,
- Figur 4: einen erfindungsgemäßen Schritt zur Ausbildung eines irreversiblen/permanenten Bonds zwischen den Substraten,
- Figur 5: eine vergrößerte Darstellung der an den beiden Kontaktflächen während der Schritte gemäß Figur 3 und Figur 4 ablaufenden chemischen/physikalischen Vorgängen,
- Figur 6: eine weiter vergrößerte Darstellung der an der Grenzfläche zwischen den beiden Kontaktflächen ablaufenden chemischen/physikalischen Vorgänge während der Schritte gemäß Figur 3 und Figur 4 und
- Figur 7: ein Diagramm zur erfindungsgemäßen Erzeugung des Reservoirs.

In den Figuren sind gleiche oder gleichwirkende Merkmale mit den gleichen Bezugszeichen gekennzeichnet.

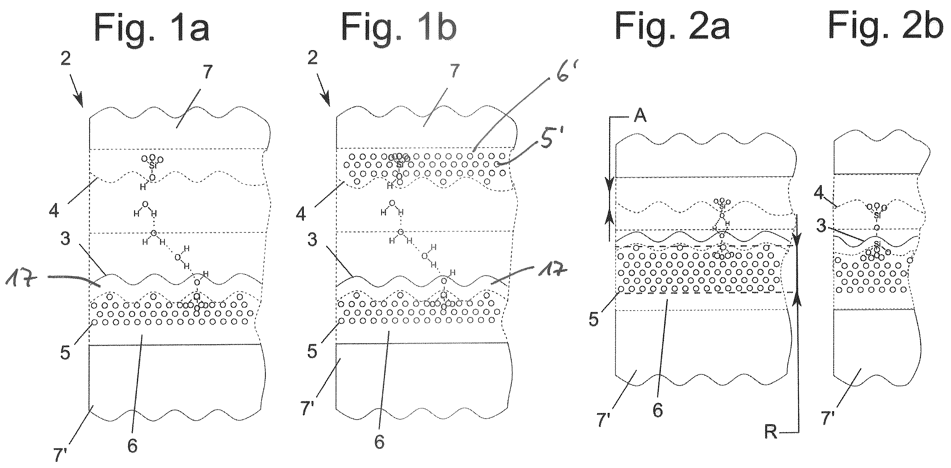

In der in Figur 1a dargestellten Situation, die nur einen Ausschnitt der beim oder unmittelbar nach dem Pre-Bond-Schritt zwischen einer ersten Kontaktfläche 3 eines ersten Substrats 1 und einer zweiten Kontaktfläche 4 eines zweiten Substrats 2 ablaufenden chemischen Reaktionen dargestellt. Die Oberflächen sind mit polaren OH-Gruppen terminiert und entsprechend hydrophil. Das erste Substrat 1 und das zweite Substrat 2 werden durch die Anziehungskraft der Wasserstoffbrücken zwischen den an der Oberfläche vorhandenen OH-Gruppen und den H₂O-Molekülen sowie zwischen den H₂O-Molekülen allein gehalten. Die Hydrophilizität zumindest des ersten Substrats 1 ist in einem vorangegangenen Schritt durch eine Plasmabehandlung erhöht worden.

Besonders vorteilhaft ist es, gemäß der alternativen Ausführungsform zusätzlich das zweite Substrat 2 beziehungsweise die zweite Kontaktfläche 4 einer Plasmabehandlung zu unterziehen, insbesondere gleichzeitig mit der Plasmabehandlung des ersten Substrats 1.

Durch die Plasmabehandlung ist erfindungsgemäß ein Reservoir 5 in einer aus thermischem Siliziumdioxid bestehenden Reservoirbildungsschicht 6 sowie bei der alternativen Ausführungsform gemäß Figur 1b ein zweites, gegenüberliegendes Reservoir 5' in der Reservoirbildungsschicht 6' ausgebildet worden. Unter den Reservoirbildungsschichten 6, 6'schließen sich jeweils unmittelbar Reaktionsschichten 7, 7' an, die ein zweites Edukt oder eine zweite Gruppe von Edukten enthalten. Durch die Plasmabehandlung mit O₂-Ionen mit Ionenenergien im Bereich zwischen 0 und 2000 eV wird eine mittlere Dicke R des Reservoirs 5 von etwa 15 nm erreicht, wobei die Ionen Kanäle beziehungsweise Poren in der Reservoirbildungsschicht 6 ausbilden.

Ebenfalls vor dem in Figur 1 gezeigten Schritt und nach der Plasmabehandlung wird das Reservoir 5 (und ggf. das Reservoir 5') zumindest überwiegend mit H₂O als erstes Edukt aufgefüllt. Im Reservoir können sich auch reduzierte Spezies der im Plasmaprozess vorhandenen Ionen befinden, insbesondere O₂, N₂, H₂, Ar.

Auf das Reservoir 5 wird eine sehr dünne Reaktionsschicht 17 aufgebracht, die das zweite Edukt enthält. Die Reaktionsschicht 17 wird durch eines oder mehrere der nachfolgend genannten Verfahren aufgebracht:
- PECVD,
- LPCVD,
- Aufdampfen und
- Epitaxie.
- MOCVD

Somit ist es bei der vorliegenden Erfindung vorteilhaft möglich, die Reservoirs als dickere, insbesondere amorphe, Oxidschicht auszubilden, da ggf. zusätzlich zu unter den Reservoirbildungsschichten 6, 6' Reaktionsschichten 7, 7' vorgesehen sind, die ebenfalls das zweite Edukt enthalten, nämlich im vorliegend beschriebenen Ausführungsbeispiel Silizium.

Die Kontaktflächen 3, 4 weisen nach Kontaktierung in dem in den Figuren 1a und 1b gezeigten Stadium noch einen relativ weiten Abstand auf, insbesondere bedingt durch das zwischen den Kontaktflächen 3, 4 vorhandene Wasser. Entsprechend ist die vorhandene Bondstärke relativ gering und liegt etwa zwischen 100 mJ/cm² und 300 mJ/cm², insbesondere über 200 mJ/cm². Hierbei spielt die vorherige Plasmaaktivierung, insbesondere wegen der erhöhten Hydrophilizität der plasmaaktivierten ersten Kontaktfläche 3 sowie einem durch die Plasmaaktivierung verursachten Glättungseffekt, eine entscheidende Rolle.

Der in Fig. 1 dargestellte, als Prebond bezeichnete, Vorgang kann vorzugsweise bei Umgebungstemperatur oder maximal 50 °C ablaufen. Die Fig. 2a und 2b zeigen einen hydrophilen Bond, wobei die Si-O-Si Brücke unter Abspaltung von Wasser durch -OH terminierte Oberflächen zustande kommt. Die Vorgänge in Fig. 2a und 2b dauern bei Raumtemperatur ca. 300 h. Bei 50 °C ca. 60 h. Der Zustand in Fig. 2b tritt ohne Herstellung des Reservoirs 5 (bzw. der Reservoirs 5, 5') bei den genannten Temperaturen nicht auf.

Zwischen den Kontaktflächen 3, 4 werden H₂O-Moleküle gebildet, die zumindest teilweise für eine weitere Auffüllung im Reservoir 5 sorgen, soweit noch Freiraum vorhanden ist. Die übrigen H₂O-Moleküle werden entfernt. In der Stufe gemäß Figur 1 sind etwa 3 bis 5 Einzelschichten von OH-Gruppen beziehungsweise H₂O vorhanden und vom Schritt gemäß Figur 1 zum Schritt gemäß Figur 2a werden 1 bis 3 Monolagen von H₂O entfernt beziehungsweise im Reservoir 5 aufgenommen.

In dem in Figur 2a gezeigten Schritt sind die Wasserstoffbrückenbindungen nunmehr unmittelbar zwischen Siloxan-Gruppen gebildet, wodurch eine stärkere Bondkraft entsteht. Hierdurch werden die Kontaktflächen 3, 4 stärker aneinander gezogen und der Abstand zwischen den Kontaktflächen 3, 4 wird reduziert. Es liegen dementsprechend nur noch 1 bis 2 Einzelschichten von OH-Gruppen zwischen den Kontaktflächen 1, 2 vor.

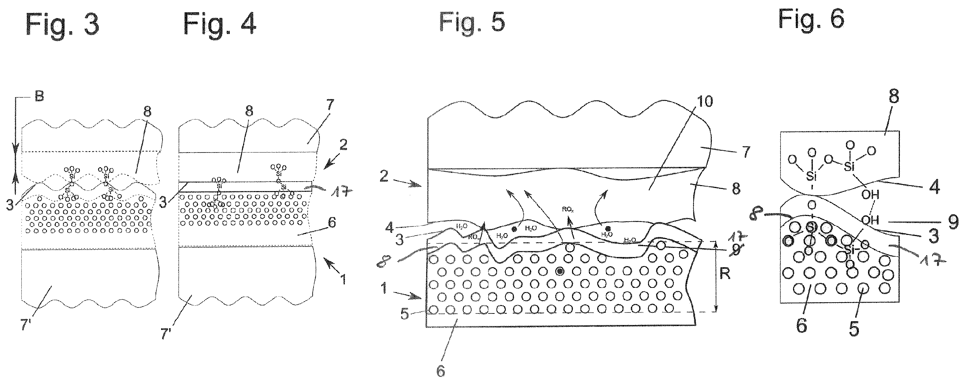

In dem in Figur 2b gezeigten Schritt werden nunmehr wiederum unter Abscheidung von H₂O-Molekülen gemäß nachfolgend eingeblendeter Reaktion kovalente Verbindungen in Form von Silanol-Gruppen zwischen den Kontaktflächen 3, 4 gebildet, die zu einer deutlich stärkeren Bondkraft führen und weniger Platz benötigen, so dass der Abstand zwischen den Kontaktflächen 3, 4 weiter verringert wird, bis schließlich der in Figur 3 gezeigte minimale Abstand auf Grund des direkten Aufeinandertreffens der Kontaktflächen 3, 4 erreicht wird:

Si-OH + HO-Si ←→ Si-O-Si+H₂O

Bis zur Stufe 3 ist es, insbesondere wegen der Schaffung des Reservoirs 5 (und ggf. des zusätzlichen Reservoirs 5'), nicht notwendig, die Temperatur übermäßig zu erhöhen, eher sogar bei Raumtemperatur ablaufen zu lassen. Auf diese Weise ist ein besonders schonender Ablauf der Verfahrensschritte gemäß Figur 1 bis Figur 3 möglich.

In dem in Figur 4 gezeigten Verfahrensschritt wird die Temperatur mit Vorzug auf maximal 500 °C, mit größerem Vorzug auf maximal 300 °C mit noch größerem Vorzug auf maximal 200 °C, mit größtem Vorzug auf maximal 100 °C, mit allergrößtem Vorzug nicht über Raumtemperatur erhöht, um einen irreversiblen beziehungsweise permanenten Bond zwischen der ersten und der zweiten Kontaktfläche zu schaffen. Ohne die zusätzliche Reaktionsschicht 17 wäre nur eine Bondstärke möglich, die von der effektiven Kontaktfläche zwischen den Oxiden abhängig ist, welche wiederum von der Oberflächenrauigkeit abhängt. Die im Gegensatz zum Stand der Technik, relativ niedrigen Temperaturen sind nur möglich, weil das Reservoir 5 (und ggf. zusätzlich das Reservoir 5') das erste Edukt für die in Figur 5 und 6 gezeigte Reaktion umfasst und zusätzlich die Reaktionsschicht 17 vorgesehen ist, die den Abstand zwischen den Reservoirs 5, 5' und/oder den Kontaktflächen 4, 5 und der Reaktionsschicht 17 verringert beziehungsweise zusätzliche Reaktionsfläche zu den vorhandenen Reaktionsschichten 7, 7' schafft:

Si + 2H₂O → SiO₂ + 2H₂

Durch Vergrößerung des molaren Volumens und Diffusion der H₂O-Moleküle wächst insbesondere an der Grenzfläche zwischen der Reservoirbildungsschicht 6' und der Reaktionsschicht 7 17 (und ggf. zusätzlich an der Grenzfläche zwischen der Reservoirbildungsschicht 6 und den Reaktionsschichten 7', 17) Volumen in Form einer Aufwuchsschicht 8 an, wobei wegen des Ziels einer Minimierung der freien Gibb'schen Enthalpie ein verstärktes Anwachsen in Bereichen erfolgt, wo Lücken 9 zwischen den Kontaktflächen 3, 4 vorhanden sind. Durch die Volumenerhöhung der Aufwuchsschicht 8 werden die Lücken 9 geschlossen. Hierzu genauer:

Bei den obengenanten, leicht erhöhten Temperaturen diffundieren H₂O-Moleküle als erstes Edukt von dem Reservoir 5 (beziehungsweise den Reservoirs 5, 5') zur (nächstgelegenen, erfindungsgemäß vorgesehenen) Reaktionsschicht 7, 7', 17. Diese Diffusion kann entweder über einen Direktkontakt der als Oxidschichten ausgebildeten Reservoirbildungsschicht 6, 6' mit der jeweiligen Reaktionsschicht 7, 7', 17 oder über eine/aus einer zwischen den Oxidschichten vorliegende Lücke 9 erfolgen. Dort wird Siliziumdioxid, also eine chemische Verbindung mit einem größeren molaren Volumen als reines Silizium, als Reaktionsprodukt 10 der obigen Reaktion aus der Reaktionsschicht 7 gebildet. Das Siliziumdioxid wächst an der Grenzfläche der Reaktionsschicht 7 mit der Aufwuchsschicht 8 und/oder der Reservoirbildungsschicht 6, 6' an und formt dadurch die Aufwuchsschicht 8 in Richtung der Lücken 9 aus. Auch hierbei werden H₂O-Moleküle aus dem Reservoir benötigt.

Durch die Existenz der Lücken, die im Nanometerbereich liegen, besteht die Möglichkeit des Ausbeulens der Aufwuchsschicht 8, wodurch Spannungen an den Kontaktflächen 3, 4 reduziert werden können. Hierdurch wird der Abstand zwischen den Kontaktflächen 3, 4 reduziert, wodurch sich die wirksame Kontaktfläche und damit die Bondstärke weiter erhöhen. Die so zustande gekommene, sich über den gesamten Wafer ausbildende, alle Poren verschließende, Schweißverbindung trägt, im Gegensatz zu den partiell nicht verschweißten Produkten im Stand der Technik, fundamental zur Erhöhung der Bondkraft bei. Erfindungsgemäß ist vorgesehen, dass die Reaktionsschicht 17 im Wesentlichen vollständig durch die Reaktion verbraucht wird, so dass die Reservoirbildungsschichten 6, 6' am Ende in direktem Kontakt stehen. Der Bindungstyp zwischen beiden miteinander verschweißten amorphen Siliziumoxidoberflächen ist eine Mischform mit kovalentem und ionischem Anteil.

Besonders schnell beziehungsweise bei möglichst niedrigen Temperaturen erfolgt die oben genannte Reaktion des ersten Edukts (H₂O) mit dem zweiten Edukt (Si) in der Reaktionsschicht 7, soweit ein mittlerer Abstand B zwischen der ersten Kontaktfläche 3 und der Reaktionsschicht 7 möglichst gering ist.

Entscheidend ist daher die Vorbehandlung des ersten Substrats 1 sowie die Vorbehandlung des zweiten Substrats 2, die jeweils aus einer Reaktionsschicht 7, 7' aus Silizium und einer amorphen Oxidschicht als Reservoir 5, 5' besteht. Eine möglichst dünne Reaktionsschicht 17 ist aus zwei Gründen erfindungsgemäß zusätzlich vorgesehen. Die Reaktionsschicht 17 ist sehr dünn, damit sie sich durch das neu gebildete Reaktionsprodukt 10 an einer der Reaktionsschichten 7, 7', 17 zur Reservoirbildungsschicht 6, 6' des jeweils gegenüberliegenden Substrats 1, 2 hin ausbeulen kann, und zwar vorwiegend in Bereichen der Nano-Lücken 9. Des Weiteren sind möglichst kurze Diffusionswege erwünscht, um den erwünschten Effekt möglichst rasch und bei möglichst niedriger Temperatur zu erzielen. Das erste Substrat 1 besteht ebenfalls aus einer Siliziumschicht und einer darauf erzeugten Oxidschicht als Reservoirbildungsschicht 6, in der zumindest teilweise oder vollständig das Reservoir 5 ausgebildet wird.

In dem Reservoir 5 (beziehungsweise den Reservoirs 5, 5') wird erfindungsgemäß mindestens die zum Schließen der Nano-Lücken 9 erforderliche Menge an erstem Edukt aufgefüllt, damit ein optimales Aufwachsen der Aufwuchsschicht 8 zum Schließen der Nano-Lücken 9 in möglichst kurzer Zeit und/oder bei möglichst geringer Temperatur erfolgen kann.

### Verfahren zum permanenten Bonden von Wafern

### Bezugszeichenliste

- 1: erstes Substrat
- 2: zweites Substrat
- 3: erste Kontaktfläche
- 4: zweite Kontaktfläche
- 5, 5': Reservoir
- 6, 6': Reservoirbildungsschicht
- 7, 7': Reaktionsschicht
- 8: Aufwuchsschicht
- 9: Nano-Lücken 10 Reaktionsprodukt
- 11: Erstes Profil
- 12: Zweites Profil
- 13: Summenkurve
- 17: Reaktionsschicht
- A: mittlere Dicke
- B: mittlerer Abstand
- R: mittlere Dicke

## Patentansprüche

1. Verfahren zum Bonden einer ersten Kontaktfläche (3) eines ersten Substrats (1) mit einer zweiten Kontaktfläche (4) eines zweiten Substrats (2) mit folgendem Ablauf:
- Ausbildung mindestens eines Reservoirs (5, 5') in mindestens einer Reservoirbildungsschicht (6, 6') an dem ersten Substrat (1) und/oder dem zweiten Substrat (2), wobei das Reservoir (5, 5'), insbesondere zumindest überwiegend, aus einem amorphen Material besteht und wobei die Ausbildung mindestens eines der Reservoirs (5, 5') durch Verwendung einer Tetraethoxisilan-Oxidschicht als Reservoirbildungsschicht (6, 6') erfolgt,
- zumindest teilweises Auffüllen des/der Reservoirs (5, 5') mit einem ersten Edukt oder einer ersten Gruppe von Edukten,
- Ausbildung oder Aufbringung einer ein zweites Edukt oder eine zweite Gruppe von Edukten enthaltenden Reaktionsschicht (17) auf das/die Reservoirs (5, 5'),
- Kontaktieren der ersten Kontaktfläche (3) mit der zweiten Kontaktfläche (4) zur Ausbildung einer Pre-Bond-Verbindung,
- Ausbildung eines permanenten Bonds zwischen der ersten und zweiten Kontaktfläche (3, 4), zumindest teilweise verstärkt durch Reaktion des ersten Edukts oder der ersten Gruppe mit dem zweiten Edukt oder der zweiten Gruppe.

2. Verfahren nach Anspruch 1, bei dem Ausbildung und/oder Verstärkung des permanenten Bonds durch Diffusion des ersten Edukts in die Reaktionsschicht (17) erfolgt.

3. Verfahren nach einem der vorhergehenden Ansprüche, bei dem die Ausbildung des permanenten Bonds bei einer Temperatur zwischen Raumtemperatur und 200 °C, insbesondere während maximal 12 Tagen, vorzugsweise maximal 1 Tag, noch bevorzugter maximal 1 Stunde, am besten maximal 15 Minuten erfolgt.

4. Verfahren nach einem der vorhergehenden Ansprüche, bei dem der irreversible Bond eine Bondstärke von größer 1,5 J/m², insbesondere größer 2 J/m², vorzugsweise größer 2,5 J/m² aufweist.

5. Verfahren nach einem der vorhergehenden Ansprüche, bei dem bei der Reaktion ein Reaktionsprodukt (10) mit einem größeren molaren Volumen als das molare Volumen des zweiten Edukts in der Reaktionsschicht (17) gebildet wird.

6. Verfahren nach einem der vorhergehenden Ansprüche, bei dem die lteservoirbildungsschicht (6, 6') im Wesentlichen vollständig, aus einem amorphen Material, insbesondere einem durch thermische Oxidation erzeugten Siliziumdioxid, und die Reaktionsschicht (17) aus einem oxidierbaren Material, insbesondere überwiegend, vorzugsweise im Wesentlichen vollständig, aus Si, Ge, InP, GaP oder GaN, bestehen.

7. Verfahren nach einem der vorhergehenden Ansprüche, bei dem das erste Substrat (1) eine weitere Reaktionsschicht (7) und/oder das zweite Substrat (2) eine weitere Reaktionsschicht (7'), zumindest überwiegend bestehend aus dem zweiten Edukt oder der zweiten Gruppe, unter den Reservoirbildungsschichten (6, 6') aufweisen.

8. Verfahren nach Anspruch 7, bei dem die Reservoirbildungsschicht (6, 6') vor der Ausbildung eines permanenten Bonds eine mittlere Dicke A zwischen 1 Angström und 10 nm aufweisen.

9. Verfahren nach einem der vorhergehenden Ansprüche, bei dem die Reservoirbildungsschicht (6, 6') und/oder die Reaktionsschicht (17) als Aufwuchsschicht (8) wirken.

10. Verfahren nach einem der vorhergehenden Ansprüche, bei dem das Auffüllen des Reservoirs (5, 5') durch einen oder mehrere der nachfolgend aufgeführten Schritte erfolgt:
- Aussetzen der ersten (3) und/oder zweiten Kontaktfläche (4) gegenüber der Atmosphäre, insbesondere mit einem hohen Sauerstoff- und/oder Wassergehalt.
- Beaufschlagung der ersten (3) und/oder zweiten Kontaktfläche (4) mit einem, insbesondere überwiegend, vorzugsweise nahezu vollständig, aus, insbesondere deionisiertem, H₂O und/oder H₂O₂ bestehenden, Fluid,
- Beaufschlagung der ersten (3) und/oder zweiten Kontaktfläche (4) mit N₂-Gas und/oder O₂-Gas und/oder Ar-Gas und/oder Formiergas, insbesondere bestehend aus 95% Ar und 5% H₂, insbesondere mit einer Ionenenergie im Bereich von 0 bis 200 eV.

11. Verfahren nach einem der vorhergehenden Ansprüche, bei dem der mittlere Abstand (B, B') zwischen dem Reservoir (5, 5') und der Reaktionsschicht (7, 7') unmittelbar vor der Ausbildung des permanenten Bonds zwischen 0,1 nm und 15 nm, insbesondere zwischen 0,5 nm und 5 nm, vorzugsweise zwischen 0,5 nm und 3 nm beträgt.

12. Verfahren nach einem der vorhergehenden Ansprüchen, bei dem der irreversible Bond eine Bondstärke besitzt, welche das 2fache, mit Vorzug das 4fache, mit größerem Vorzug das 10fache, mit größtem Vorzug das 25fache der Prebondstärke ausmachen.

## Claims

1. A method for bonding of a first contact surface (3) of a first substrate (1) to a second contact surface (4) of a second substrate (2) with the following sequence:
- forming at least one reservoir (5, 5') in at least one reservoir formation layer (6, 6') on the first substrate (1) and/or the second substrate (2), the reservoir (5, 5') consisting especially at least largely of an amorphous material, and wherein the forming of the at least one reservoir (5, 5') as reservoir formation layer (6, 6') is made by use of a tetraethoxysilane-oxide layer
- at least partial filling of the reservoir/reservoirs (5, 5') with a first educt or a first group of educts,
- forming or applying a reaction layer (17) which contains a second educt or a second group of educts to the reservoirs (5, 5'),
- bringing the first contact surface (3) in contact with the second contact surface (4) for formation of a prebond connection,
- forming a permanent bond between the first and second contact surface (3, 4), at least partially strengthened by the reaction of the first educt or the first group with the second educt or the second group.

2. The method as claimed in Claim 1, wherein formation and/or strengthening of the permanent bond takes place by diffusion of the first educt into the reaction layer (17).

3. The method as claimed in one of the preceding claims, wherein the formation of the permanent bond takes place at a temperature between room temperature and 200°C, especially during a maximum 12 days, preferably a maximum 1 day, even more preferably a maximum 1 hour, best a maximum 15 minutes.

4. The method as claimed in one of the preceding claims, wherein the irreversible bond has a bond strength of greater than 1.5 J/m², especially greater than 2 J/m², preferably greater than 2.5 J/m².

5. The method as claimed in one of the preceding claims, wherein during the reaction a reaction product (10) with a greater molar volume than the molar volume of the second educt is formed in the reaction layer (17).

6. The method as claimed in one of the preceding claims, wherein the reservoir formation layer (6, 6') consists essentially completely of an amorphous material, in particular a silicon dioxide produced by thermal oxidation, and the reaction layer (17) consists of an oxidizable material, in particular predominantly, preferably essentially completely, of Si, Ge, InP, GaP or GaN.

7. The method as claimed in one of the preceding claims, wherein the first substrate (1) has a further reaction layer (7) and/or the second substrate (2) has a further reaction layer (7') beneath the reservoir formation layers (6, 6'), at least largely consisting of the second educt or the second group.

8. The method as claimed in Claim 7, wherein before the formation of a permanent bond the reservoir formation layer (6, 6') has an average thickness A between 1 angstrom and 10 nm,

9. The method as claimed in one of the preceding claims, wherein the reservoir formation layer (6, 6') and/or the reaction layer (17) act as growth layer (8).

10. The method as claimed in one of the preceding claims, wherein the reservoir (5, 5') is filled by one or more of the steps cited below:
- exposing the first (3) and/or second contact surface (4) to the atmosphere, especially with a high oxygen and/or water content,
- exposing the first (3) and/or the second contact surface (4) to a fluid consisting especially predominantly, preferably almost completely, of especially deionized H₂O and/or H₂O₂,
- exposing the first (3) and/or second contact surface (4) to N₂ gas and/or O₂ gas and/or Ar gas and/or forming gas, especially consisting of 95% Ar and 5% H₂, especially with an ion energy in the range from 0 to 200 eV.

11. The method as claimed in one of the preceding claims, wherein the average distance (B, B') between the reservoir (5, 5') and the reaction layer (7, 7') immediately before formation of the permanent bond is between 0.1 nm and 15 nm, especially between 0.5 nm and 5 nm, preferably between 0.5 nm and 3 nm.

12. The method as claimed in one of the preceding claims, wherein the irreversible bond has a bond strength which comprises twice, preferably 4 times, more preferably 10 times, most preferably 25 times the prebond strength.

## Revendications

1. Procédé destiné à la liaison d'une première surface de contact (3) d'un premier substrat (1) à une seconde surface de contact (4) d'un second substrat (2) comprenant le déroulement suivant :
- formation d'au moins un réservoir (5, 5') dans au moins une couche de formation de réservoir (6, 6') sur le premier substrat (1) et/ou le second substrat (2), sachant que le réservoir (5, 5') est composé, en particulier au moins majoritairement, d'un matériau amorphe, et sachant que la formation d'au moins un des réservoirs (5, 5') est réalisée par l'emploi d'une couche d'oxyde de tétraéthoxysilane en tant que couche de formation de réservoir (6, 6'),
- remplissage au moins partiel du/des réservoir(s) (5, 5') avec un premier réactif ou un premier groupe de réactifs,
- formation ou application sur le/les réservoir(s) (5, 5') d'une couche réactionnelle (17) comprenant un second réactif ou un second groupe de réactifs,
- mise en contact de la première surface de contact (3) avec la seconde surface de contact (4) pour former une liaison pré-liée,
- formation d'une liaison permanente entre les première et seconde surface(s) de contact (3, 4), renforcée au moins partiellement par la réaction du premier réactif ou du premier groupe avec le second réactif ou le second groupe.

2. Procédé selon la revendication 1, dans lequel la formation et/ou le renforcement de la liaison permanente a lieu par diffusion du premier réactif dans la couche réactionnelle (17).

3. Procédé selon l'une des revendications précédentes, dans lequel la formation de la liaison permanente a lieu à une température située entre la température ambiante et 200°C, en particulier pendant 12 jours au maximum, de préférence 1 jour au maximum, plus encore de préférence 1 heure au maximum, au mieux de 15 minutes au maximum.

4. Procédé selon l'une des revendications précédentes, dans lequel la liaison irréversible présente une épaisseur de liaison supérieure à 1,5 J/m², en particulier supérieure à 2 J/m², de préférence supérieure à 2,5 J/m².

5. Procédé selon l'une des revendications précédentes, dans lequel un produit rédactionnel (10) ayant un volume molaire supérieur au volume molaire du second réactif dans la couche réactionnelle (17) est produit lors de la réaction.

6. Procédé selon l'une des revendications précédentes, dans lequel la couche de formation de réservoir (6, 6') est essentiellement intégralement composée d'un matériau amorphe, en particulier d'un dioxyde de silicium produit par oxydation thermique, et la couche réactionnelle (17) est composée d'un matériau oxydable, en particulier majoritairement, de préférence essentiellement intégralement, de Si, Ge, InP, GaP ou de GaN.

7. Procédé selon l'une des revendications précédentes, dans lequel le premier substrat (1) présente une couche réactionnelle supplémentaire (7) et/ou le second substrat (2) présente une couche réactionnelle supplémentaire (7'), composée au moins majoritairement d'un second réactif ou du second groupe, sous les couches de formation de réservoir (6, 6').

8. Procédé selon la revendication 7, dans lequel la couche de formation de réservoir (6, 6') présente une épaisseur moyenne A entre 1 Angstrom et 10 nm avant la formation d'une liaison permanente.

9. Procédé selon l'une des revendications précédentes, dans lequel la couche de formation de réservoir (6, 6') et/ou la couche réactionnelle (17) agissent en tant que couche de croissance (8).

10. Procédé selon l'une des revendications précédentes, dans lequel le remplissage du réservoir (5, 5') a lieu par l'une ou plusieurs des étapes listées suivantes :
- exposition de la première (3) et/ou de la seconde surface de contact (4) à l'atmosphère, en particulier avec une teneur en oxygène et/ou en eau élevée,
- alimentation de la première (3) et/ou de la seconde surface de contact (4) avec un fluide composé en particulier majoritairement, de préférence presque intégralement, d'H₂O et/ou d'H₂O₂, en particulier désionisé,
- alimentation de la première (3) et/ou de la seconde surface de contact (4) avec un gaz N₂ et/ou un gaz O₂ et/ou un gaz Ar et/ou un gaz de protection, en particulier composé de 95 % d'Ar et de 5 % H₂, en particulier avec une énergie ionique de l'ordre de 0 à 200 eV.

11. Procédé selon l'une des revendications précédentes, dans lequel l'écart moyen (B, B') entre le réservoir (5, 5') et la couche réactionnelle (7, 7') fait, directement avant la formation de la liaison permanente, entre 0,1 nm et 15 nm, en particulier entre 0,5 nm et 5 nm, de préférence entre 0,5 nm et 3nm.

12. Procédé selon l'une des revendications précédentes, dans lequel la liaison irréversible possède une épaisseur de liaison qui fait 2 fois, de préférence 4 fois, plus encore de préférence 10 fois, de manière la plus préférée 25 fois l'épaisseur de pré-liaison.
